# EUROPEAN PATENT APPLICATION

(11) **EP 4 847 925 A1**
(43) Date of publication of application: **02.12.2026**
(21) Application number: 25179582.9
(22) Date of filing: 28.05.2025
(51) Int. Cl.: G01R 27/02, G01R 31/00, G01R 31/36, G01R 31/52

(54) **MEASUREMENT CIRCUIT AND METHOD FOR ISOLATION RESISTANCE MEASUREMENT**

(71) Applicant: SAMSUNG SDI CO., LTD., Yongin-si, Gyeonggi-do 17084 (KR)
(72) Inventor: Gombats, Ilya, 8020 Graz (AT); Kurcik, Peter, 8505 St. Nikolai im Sausal (AT); Giho, Seo, Suwon-si, Gyeonggi-do (KR); Seunghoon, Kim, Suwon-si, Gyeonggi-do (KR)
(74) Representative: Gulde & Partner

(57) **Abstract**

The present disclosure refers to a measurement circuit and a corresponding method for measuring an isolation resistance of a battery pack (10).

A measurement circuit for measuring an isolation resistance of a battery pack (10) includes: a first electric connection comprising a first resistor (R1) and a controllable first switch (Sw1) in series connection, and connecting a positive pole (BATP) of the battery pack (10) to a chassis ground (CHASSIS-GND), and a second electric connection comprising a second resistor (R2) and a controllable second switch (Sw2) in series connection, and connecting a negative pole (BATM) of the battery pack (10) to the chassis ground (CHASSIS-GND), wherein a common connection from the first resistor (R1) and the second resistor (R2) to the chassis ground (CHASSIS-GND) comprises a third resistor (R3) in series connection, and wherein, when the first switch (Sw1) is closed and the second switch (Sw2) is open, a first voltage drop over the first resistor (R1) and the first switch (Sw1) is measurable by a first voltmeter (V1), and, when the first switch (Sw1) is open and the second switch (Sw2) is closed, a second voltage drop over the second resistor (R2) and the second switch (Sw2) is measurable by a second voltmeter (V2).

## Description

### Field of the Disclosure

Embodiments of the present disclosure relate to a measurement circuit and a corresponding method for measuring an isolation resistance of a battery pack.

### Technological Background

Recently, vehicles for transportation of goods and peoples have been developed that use electric power as a source for motion. Such an electric vehicle is an automobile that is propelled permanently or temporarily by an electric motor using energy stored in rechargeable batteries. An electric vehicle may be solely powered by batteries (Battery Electric Vehicle BEV) or may include a combination of an electric motor and, for example, a conventional combustion engine (Plugin Hybrid Electric Vehicle PHEV). BEVs and PHEVs use high-capacity rechargeable batteries, which are designed to provide power for propulsion over sustained periods of time.

Generally, a rechargeable (or secondary) battery cell includes an electrode assembly including a positive electrode, a negative electrode, and a separator interposed between the electrodes. A solid or liquid electrolyte allows movement of ions during charging and discharging of the battery cell. The electrode assembly is located in a casing and electrode terminals, which are positioned on the outside of the casing, establish an electrically conductive connection to the electrodes. Common battery cell formats, include, for example, cylindrical, prismatic, and pouch.

A battery module is formed of a plurality of battery cells connected together in series or in parallel. That is, the battery module is formed by interconnecting the electrode terminals of the plurality of battery cells depending on a desired amount of power and in order to realize a high-power rechargeable battery.

Battery modules can be constructed either in a block design or in a modular design. In the block design each battery cell is coupled to a common current collector structure and a common cell management unit and arranged in a housing. In the modular design, pluralities of battery cells are connected together to form submodules and several submodules are connected together to form the battery module. In automotive applications, battery systems often include a plurality of battery modules connected together in series to provide a desired voltage.

A battery pack is a set of any number of (for example identical) battery modules and/or single battery cells. The battery modules, respectively battery cells, may be configured in a series, parallel or a mixture of both to deliver the desired voltage, capacity, and/or power density. Components of a battery pack include the individual battery modules, and the interconnects, which provide electrical conductivity between the battery modules.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge, SoC, potential electrical performance, charging ability and internal resistance as well as actual or predicted power demands or surpluses of the consumers. Therefore, battery systems usually include a battery management system, BMS, for obtaining and processing such information on system level and further a plurality of battery module managers, BMMs, which are part of the system's battery modules and obtain and process relevant information on module level. Particularly, the BMS usually measures the system voltage, the system current, the local temperature at different places inside the system housing, and the insulation resistance between live components and the system housing. Additionally, the BMMs usually measure the individual cell voltages and temperatures of the battery cells in a battery module.

Thus, the BMS is provided for managing the battery pack, such as by protecting the battery from operating outside its safe operating area, monitoring its state, calculating secondary data, reporting that data, controlling its environment, authenticating it and/or balancing it.

In case of an abnormal operation state, a battery pack shall usually be disconnected from a load connected to a terminal of the battery pack. Therefore, battery systems further include a battery disconnect unit, BDU, that is electrically connected between the battery module and battery system terminals. Thus, the BDU is the primary interface between the battery pack and the electrical system of the vehicle. The BDU includes electromechanical switches that open or close high current paths between the battery pack and the electrical system. The BDU provides feedback to the battery control unit, BCU, accompanied to the battery modules such as voltage and current measurements. The BCU controls the switches in the BDU using low current paths based on the feedback received from the BDU. The main functions of the BDU may thus include controlling current flow between the battery pack and the electrical system and current sensing. The BDU may further manage additional functions like external charging and pre-charging.

For ensuring the electrical isolation of high-voltage, HV, components in BEVs and PHEVs, a so-called R₀ isolation measurement method has to be implemented. This method measures the isolation resistance between the HV system and the chassis ground to ensure safety. High-voltage components in BEVs and PHEVs operate at voltages greater than 60 V, which can pose serious risks of electric shock. By measuring the isolation resistance, any degradation in the isolation can be detected early, preventing potential risks. Maintaining proper isolation thus ensures the integrity of the vehicle's electrical system. A compromised isolation can lead to leakage currents, which can damage sensitive electronic components and affect the overall performance of the vehicle.

Various regulatory bodies, such as the National Highway Traffic Safety Administration (NHTSA) and the European Union (EU), have set stringent requirements for isolation resistance in HV systems. Compliance with these regulations is mandatory for the approval and marketability of BEVs and PHEVs. The BMS relies on accurate isolation measurements to monitor the health of the battery pack. Any drop in the isolation resistance can indicate potential issues such as insulation breakdown, coolant leakage, or physical damage to the battery pack. Regular R₀ isolation measurements allow for preventive maintenance of the HV system. By identifying and addressing issues early, the longevity and reliability of the battery pack and associated components can be significantly improved.

For example, Regulation No. 100 Rev. 3 (also known as UN/ECE R100) outlines specific requirements for the approval of electric vehicles and their rechargeable energy storage systems (RESS). The regulation includes detailed procedures for calculating electric isolation to ensure the safety and reliability of high-voltage components in BEVs and PHEVs.

The electric isolation can be calculated by measuring the isolation resistance between, e.g., the HV components and the vehicle chassis. This typically involves using a high-resistance voltmeter to measure the resistance, ensuring it meets the specified thresholds to prevent electric shock and maintain system integrity.

In Annexes 5A and 5B, Regulation No. 100 Rev. 3 explicitly defines the procedures for measuring isolation resistance in electric vehicles for vehicle or component based tests. The vehicle's HV system must be powered on, and a high-resistance voltmeter with an internal resistance greater than 10 MΩ should be used. The voltmeter is to be connected between the HV components and the vehicle chassis. Depending on the measured voltages, a standard known resistance (referred to as a resistance R₀o) is to be inserted between the negative or positive side of the high voltage bus and the electrical chassis. After a selection decision, the voltage between the negative side or the positive side of the high voltage bus and the electrical chassis is measured again with the resistance installed, and the electrical isolation (Rᵢ) can be calculated. Acceptable isolation resistance values are defined, typically requiring a resistance greater than 500 Ω/V. For instance, the NHTSA specifies values of over 3,000 kΩ when contactors are open and over 2,000 kΩ when contactors are closed. The BMS should continuously monitor the isolation resistance to detect any degradation over time. This ensures that the HV system is properly isolated from the chassis, reducing the risk of electric shock and enhancing the safety of the vehicle.

However, for the implementation of a cost effective isolation resistance measurement, required switches and the measurements are often based on a low-voltage, LV, ground of the electrical system (e.g., typically on "Clamp31" or CL31) and the method relies on an external connection between said LV ground and a chassis ground. If this connection is damaged or not existing, the standard isolation measurement still reports a measurement value, however this is not the value of the isolation resistance between the battery poles and the chassis ground. There may thus a problem that the measured R₀ isolation value does not represent the value to be measured due to different ground potentials of the LV system and the chassis ground of the vehicle. Damages may occur in case there is externally applied ground shift between chassis ground and low-voltage ground.

Furthermore, the prior art isolation resistance measurement method does not consider the resistance between the LV ground and the chassis ground. According to Regulation No. 100 Rev. 3, it requires a decision making action after the first measurement, what makes the measurement system unpredictable in terms of an unknown discharge time of involved parasitic capacitors. Due to the typically very high isolation resistance and the absence of the measuring resistors as charging resistor in the first measurement, the prior art isolation resistance measurement method typically leads to very slow charge/discharge times for the first measurement.

### Summary of Invention

The invention is defined by the appended claims. The description that follows is subjected to this limitation. Any disclosure lying outside the scope of the claims is only intended for illustrative as well as comparative purposes.

According to an embodiment of an aspect of the present disclosure, a measurement circuit for measuring an isolation resistance of a battery pack includes: a first electric connection comprising a first resistor and a controllable first switch in series connection, and connecting a positive pole of the battery pack to a chassis ground; and a second electric connection comprising a second resistor and a controllable second switch in series connection, and connecting a negative pole of the battery pack to the chassis ground, wherein a common connection from the first resistor and the second resistor to the chassis ground comprises a third resistor in series connection, and wherein, when the first switch is closed and the second switch is open, a first voltage drop over the first resistor and the first switch is measurable by a first voltmeter, and, when the first switch is open and the second switch closed, a second voltage drop over the second resistor and the second switch is measurable by a second voltmeter.

According to another embodiment, the common connection may be further connected to a low-voltage ground.

According to another embodiment, the resistance of the third resistor may be equal to or less than 5 % of the resistance of the first resistor or the second resistor.

According to another embodiment, the common connection may further include a controllable third switch.

According to yet another embodiment, when the third switch and at least one of the first switch and the second switch are closed, a third voltage drop over the third resistor and the third switch may be measurable by a third voltmeter.

According to an embodiment of another aspect of the present disclosure, an electrical system of a vehicle includes a battery pack and the measurement circuit according to the present disclosure.

According to an embodiment of another aspect of the present disclosure, an electric vehicle includes the electrical system according to the present disclosure.

According to an embodiment of yet another aspect of the present disclosure, a method for measuring an isolation resistance of a battery pack with a measurement circuit according to the present disclosure includes: controlling the measurement circuit to a first state in which the first switch and the third switch are closed and the second switch is open, and measuring the voltages on the first to third voltmeter in the first state; controlling the measurement circuit to a second state in which the second switch and the third switch are closed and the first switch is open, and measuring the voltages on the first to third voltmeter in the second state; and controlling the measurement circuit to a third state in which the first to third switch are closed and measuring the voltages on the first to third voltmeter in the third state.

According to another embodiment, the method may further include calculating and averaging the resistance value of the third resistor individually from the measured voltages in the three states.

According to yet another embodiment, the method may further include calculating a pair of a positive isolation resistance related to the first electric connection and a negative isolation resistance related to the second electric connection for each of the three states; averaging the resulting resistances of the first isolation resistance; and averaging the resulting resistances of the negative isolation resistance.

Further embodiments of the present disclosure could be learned from the dependent claims or the following description.

### Brief Description of the Drawings

Features will become apparent to those of ordinary skill in the art by describing in detail exemplary embodiments with reference to the attached drawings in which:
- FIG. 1: illustrates a schematic circuit diagram for a prior art isolation resistance measurement circuit.
- FIG. 2: illustrates a schematic circuit diagram for an isolation resistance measurement circuit according to an embodiment.
- FIG. 3: illustrates a schematic flow diagram for a method for measuring an isolation resistance according to an embodiment.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the embodiments and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Expressions such as "at least one of", when preceding a list of elements, modify the entire list of elements and do not modify the individual elements of the list. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present disclosure.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

The term "consisting essentially of" means that specific further components can be present, namely those not materially affecting the essential characteristics of a composition.

It will also be understood that when a film, a region, or an element is referred to as being "above" or "on" another film, region, or element, it can be directly on the other film, region, or element, or intervening films, regions, or elements may also be present.

Herein, the terms "upper" and "lower" are defined according to the z-axis. For example, the upper cover is positioned at the upper part of the z-axis, whereas the lower cover is positioned at the lower part thereof. In the drawings, the sizes of elements may be exaggerated for clarity. For example, in the drawings, the size or thickness of each element may be arbitrarily shown for illustrative purposes, and thus the embodiments of the present disclosure should not be construed as being limited thereto.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of circuit carrier. The conducting elements may include metallization, e.g. surface metallizations and/or pins, and/or may include conductive polymers or ceramics. Further electrical energy might be transmitted via wireless connections, e.g. using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like.

Also, a person of skill in the art should recognize that the functionality of various computing devices may be combined or integrated into a single computing device, or the functionality of a particular computing device may be distributed across one or more other computing devices without departing from the scope of the exemplary embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

### General Concept

According to an embodiment of an aspect of the present disclosure, a measurement circuit for measuring an isolation resistance of a battery pack includes a first electric connection comprising a first resistor and a controllable first switch in series connection. The first connection connects a positive pole of the battery pack to a chassis ground. The first resistor may have a standard known resistance. The resistance value may correspond to a typical resistance value for an isolation resistance measurement according to Regulation No. 100 Rev. 3.

The measurement circuit for measuring an isolation resistance of a battery pack further includes and a second electric connection comprising a second resistor and a controllable second switch in series connection. The second connection connects a negative pole of the battery pack to the chassis ground. As the first resistor, also the second resistor may have a standard known resistance. The resistance value may correspond to a typical resistance value for an isolation resistance measurement according to Regulation No. 100 Rev. 3. The first and second resistance may have an equal or nearly equal value. They may directly correspond to a R₀ resistance specified or typically used for the standard method.

The measurement circuit for measuring an isolation resistance of a battery pack further includes a common connection from the first resistor and the second resistor to the chassis ground, which comprises a third resistor in series connection. In other words, an electric current may flow from the positive (negative) pole of the battery pack through the first (second) resistor and through the third resistor to the chassis ground.

When the first switch is closed and the second switch is open, a first voltage drop over the first resistor and the first switch is measurable by a first voltmeter, and, when the first switch is open and the second switch closed, a second voltage drop over the second resistor and the second switch is measurable by a second voltmeter. By means of the measured voltages and with the corresponding known resistance value of the related resistor, the respective current through the resistor can be calculated. From these values, the isolation resistance (Rᵢ) can then be calculated. Furthermore, the disclosed measurement circuit also allows to determine the values of a positive isolation resistance between the positive battery pole and chassis ground and a negative isolation resistance between the negative battery pole and chassis ground.

The present disclosure may thus provide an improvement over the prior art R₀ isolation measurement method by including an additional diagnosis of the resistance of the ground connection.

According to another embodiment, the common connection may be further connected to a low-voltage ground. The common connection thus provides an alternative path for connecting the chassis ground and the low-voltage ground. The diagnostic measurement between the two grounds can be used to detect if there is insufficient coupling between the grounds by performing resistance measurement between the grounds as part of the isolation measurement process.

According to another embodiment, the resistance of the third resistor may be equal to or less than 5 % of the resistance of the first resistor or the second resistor. This relation can be derived from a system of equations describing the measurement circuit and which needs to be solved to calculate the positive and negative isolation resistance. Additionally, the value of the third resistor can also be calculated. This method works whether the third resistor is in place or it is shorted by an external connection. The ratio of the third resistor to the first or second resistor shall be sufficiently low, for example, if the resistance of the first or second resistor is 500 kΩ, the third resistor may be below 25 kΩ, which is equal or less than 5 %. More preferably, it may be equal or less than 2 %. If the resistance of the third resistor is too high, it might have a negative impact on the accuracy of the isolation resistance measurement, however, the impact may be compensated by additionally taking into account the measurement of the third voltmeter which measures the voltage drop over the third resistor with the third switch in series.

According to another embodiment, the common connection may further include a controllable third switch. This gives the possibility to completely substitute a missing external connection of the two different grounds on an optional basis by closing the third switch. Due to the third resistor, which limits occurring balancing currents, a damage in case there is externally applied ground shift between chassis ground and low-voltage ground may be prevented.

According to yet another embodiment, when the third switch and at least one of the first switch and the second switch are closed, a third voltage drop over the third resistor and the third switch may be measurable by a third voltmeter. The resistance value of the third resistor current can thus be calculated and used to detect if there is insufficient coupling between the grounds and to determine the current which is going from low-voltage ground to chassis ground. It can further be used to improve the calculation of the isolation resistance.

According to an embodiment of another aspect of the present disclosure, an electrical system of a vehicle includes a battery pack and the measurement circuit according to the present disclosure.

According to an embodiment of another aspect of the present disclosure, an electric vehicle includes the electrical system according to the present disclosure.

According to an embodiment of yet another aspect of the present disclosure, a method for measuring an isolation resistance of a battery pack with a measurement circuit according to the present disclosure includes: controlling the measurement circuit to a first state in which the first switch and the third switch are closed and the second switch is open, and measuring the voltages on the first to third voltmeter in the first state; controlling the measurement circuit to a second state in which the second switch and the third switch are closed and the first switch is open, and measuring the voltages on the first to third voltmeter in the second state; and controlling the measurement circuit to a third state in which the first to third switch are closed and measuring the voltages on the first to third voltmeter in the third state. The three states may be alternatively measured one after another, either in a continuous measurement cycle or as a single measurement.

Thus, all three voltmeters are measured at each switch position combination. Different scenarios created by the first and second switch change the voltage on all three voltmeters simultaneously and need to be all read out to provide information needed to calculate the result of the isolation resistance measurement. The third switch is closed all the time when the measurement is active.

According to another embodiment, the method may further include calculating and averaging the resistance value of the third resistor individually from the measured voltages in the three states. For all three states, equations for the corresponding current-voltage relation on the respective resistor can be derived and evaluated. The resistance of the third resistor may be found individually from all three equations but may be averaged for a final result.

According to yet another embodiment, the method may further include calculating a pair of a positive isolation resistance related to the first electric connection and a negative isolation resistance related to the second electric connection for each of the three states; averaging the resulting resistances of the first isolation resistance; and averaging the resulting resistances of the negative isolation resistance. The disclosed method thus allows to calculate the positive isolation resistance and the negative isolation resistance based on a measurement circuit of the present disclosure. The positive isolation resistance and the negative positive isolation resistance may both be parasitic resistances.

The method of the present disclosure leads to improved accuracy of the isolation resistance measurement by additionally considering a possible resistance between the low-voltage ground and the chassis ground.

### Specific Embodiments

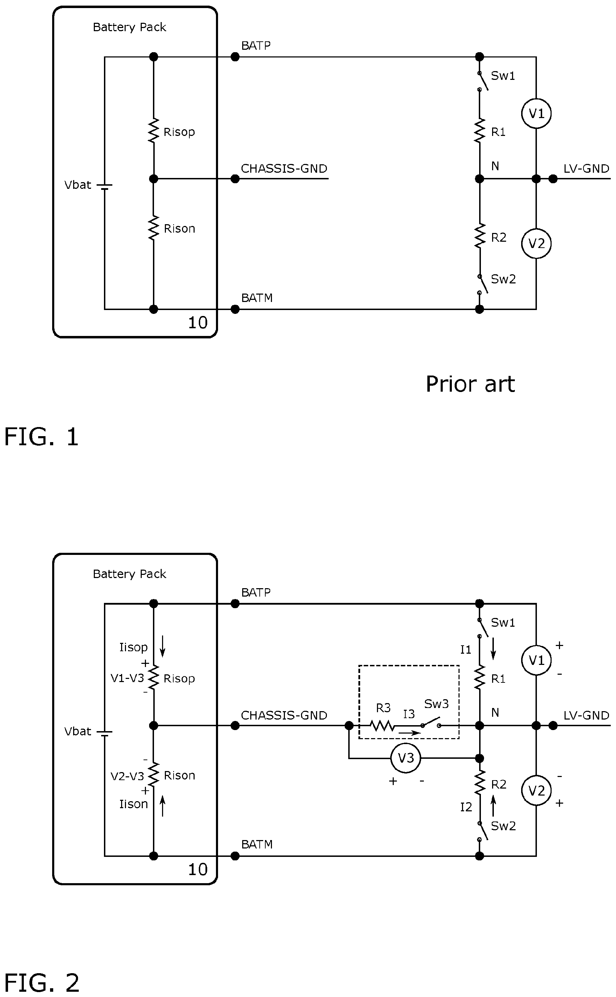

FIG. 1 is a schematic circuit diagram illustrating a prior art isolation resistance measurement circuit. The illustrated measurement circuit for measuring an isolation resistance of a battery pack 10 includes: a first electric connection comprising a first resistor R1 and a controllable first switch Sw1 in series connection, and connecting a positive pole BATP of the battery pack 10 to a low-voltage ground LV-GND; and a second electric connection comprising a second resistor R2 and a controllable second switch Sw2 in series connection, and connecting a negative pole BATM of the battery pack 10 to the low-voltage ground LV-GND. When the first switch Sw1 is closed and the second switch Sw2 is open, a first voltage drop over the first resistor R1 and the first switch Sw1 may be measurable by a first voltmeter V1, and, when the first switch Sw1 is open and the second switch Sw2 is closed, a second voltage drop over the second resistor R2 and the second switch Sw2 may be measurable by a second voltmeter V2.

Within the battery pack 10, a voltage source Vbat is connected to the positive pole BATP and the negative pole BATM of the battery pack 10. The isolation resistance can be illustrated by two equivalent isolation resistors having isolation resistances Risop and Rison. The positive isolation resistance Risop connects the positive pole BATP to the chassis ground CHASSIS-GND. The negative isolation resistance Rison connects the negative pole BATM to the chassis ground CHASSIS-GND.

The low-voltage ground LV-GND should be connected to a chassis ground CHASSIS-GND and thus both grounds typically provide a common ground potential, however, an externally applied ground shift between chassis ground CHASSIS-GND and the low-voltage ground LV-GND may occur or the connection between the low-voltage ground LV-GND and the chassis ground CHASSIS-GND may be interrupted. In these cases, both ground potentials may be different. Such deviating ground potentials may strongly compromise the standard measurement method for isolation resistance according to Regulation No. 100 Rev. 3.

FIG. 2 is a schematic circuit diagram illustrating an isolation resistance measurement circuit according to an embodiment. The illustrated measurement circuit for measuring an isolation resistance of a battery pack 10 includes: a first electric connection comprising a first resistor R1 and a controllable first switch Sw1 in series connection, and connecting a positive pole BATP of the battery pack 10 to a chassis ground CHASSIS-GND; and a second electric connection comprising a second resistor R2 and a controllable second switch Sw2 in series connection, and connecting a negative pole BATM of the battery pack 10 to the chassis ground CHASSIS-GND. When the first switch Sw1 is closed and the second switch Sw2 is open, a first voltage drop over the first resistor R1 and the first switch Sw1 is measurable by a first voltmeter V1, and, when the first switch Sw1 is open and the second switch Sw2 is closed, a second voltage drop over the second resistor R2 and the second switch Sw2 is measurable by a second voltmeter V2.

In contrast to the measurement circuit shown in FIG. 1, the illustrated measurement circuit further includes a common connection from the first resistor R1 and the second resistor R2 to the chassis ground CHASSIS-GND which comprises a third resistor R3 in series connection. In other words, the first resistor R1, the second resistor R2 and a first end of the third resistor R3 are connected in a node N. A second end of the third resistor R3 is then connected to the chassis ground CHASSIS-GND.

Within the battery pack 10, a voltage source Vbat is connected to the positive pole BATP and the negative pole BATM of the battery pack 10. The isolation resistance can be illustrated by two equivalent isolation resistors having isolation resistances Risop and Rison. The positive isolation resistance Risop connects the positive pole BATP to the chassis ground CHASSIS-GND. The negative isolation resistance Rison connects the negative pole BATM to the chassis ground CHASSIS-GND.

The common connection may be further connected to a low-voltage ground LV-GND. The low-voltage ground LV-GND may be connected to the node N. The common connection may further include a controllable third switch Sw3. When the third switch Sw3 and at least one of the first switch Sw1 and the second switch Sw2 are closed, a third voltage drop over the third resistor R3 and the third switch Sw3 is measurable by a third voltmeter V3.

Further denoted in FIG. 2 are the corresponding currents through the various resistive segments of the circuit. The first to third resistor currents I1, I2, I3 relate to the first to third resistors R1, R2, R3, respectively. Correspondingly, the positive and negative isolation resistance currents lisop, lison relate to the positive and negative equivalent isolation resistors having related positive and negative isolation resistances Risop, Rison, respectively.

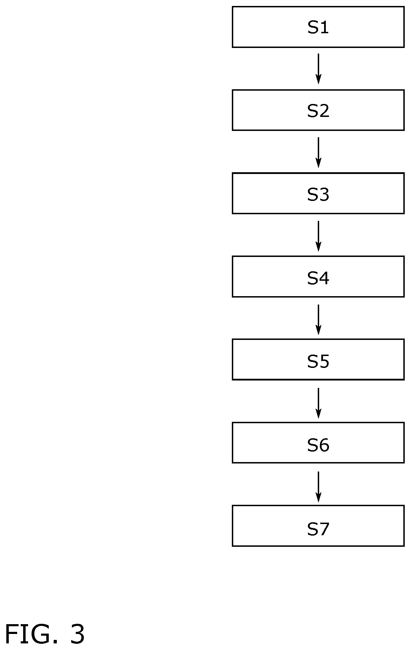

FIG. 3 is a schematic flow diagram illustrating a method for measuring an isolation resistance according to an embodiment. The illustrated method for measuring an isolation resistance of a battery pack 10 with a measurement circuit according to the present disclosure includes: controlling S1 the measurement circuit to a first state in which the first switch Sw1 and the third switch Sw3 are closed and the second switch Sw2 is open, and measuring the voltages on the first to third voltmeter V1, V2, V3 in the first state; controlling S2 the measurement circuit to a second state in which the second switch Sw2 and the third switch are closed and the first switch Sw1 is open, and measuring the voltages on the first to third voltmeter V1', V2', V3' in the second state; controlling S3 the measurement circuit to a third state in which the first to third switch Sw1, Sw2, Sw3 are closed and measuring the voltages on the first to third voltmeter V1", V2", V3" in the third state.

The method may further include: calculating and averaging S4 the resistance value of the third resistor R3 individually from the measured voltages V1, V2, V3; V1', V2', V3'; V1", V2", V3" in the three states. The method may yet further include: calculating S5 a pair of a positive isolation resistance Risop related to the first electric connection and a negative isolation resistance Rison related to the second electric connection for each of the three states; averaging S6 the resulting resistances of the positive isolation resistance Risop; and averaging S7 the resulting resistances of the negative isolation resistance Rison.

In the following, the equations for a measuring circuit according to the embodiment shown in FIG. 2 are shown and solved in order to calculate the positive insulation resistance Risop and the negative insulation resistance Rison from the measured values.

In the first state, the following equations can be derived:
*at* $CHASSIS - GND : \left(V1-V3\right) / Risop + \left(V2-V3\right) / Rison = V 3 / R 3$ *at* $LV - GND : V 1 / R 1 + V 3 / R 3 = 0$

In the second state, the following equations can be derived:
*at* $CHASSIS - GND : \left(V1′-V3′\right) / Risop + \left(V2′-V3′\right) / Rison = V 3 ′ / R 3$ *at* $LV - GND : V 2 ′ / R 2 + V 3 ′ / R 3 = 0$

In the third state, the following equations can be derived:
*at* $CHASSIS - GND : \left(V1"-V3"\right) / Risop + \left(V2"-V3"\right) / Rison = - V 3 " / R 3$ *at* $LV - GND : V 1 " / R 1 + V 2 " / R 2 + V 3 " / R 3 = 0$

From these three states, three independent equations for the resistance value of the third resistor R3 are resulting. From each of these equations the resistance value of the third resistor R3 can be individually derived. Afterwards, an average over the three resulting values can be calculated.

Furthermore, the equations can be combined to form a linear equation system from which three pairs of the positive isolation resistance Risop and the negative isolation resistance Rison can be derived with $\frac{1}{R} = G ,$ wherein the conductance G is the reciprocal of the resistance R: $\left(V1-V3\right) ∗ Gisop + \left(V2-V3\right) ∗ Gison = - V 1 ∗ G 1$
*at* $CHASSIS - GND : \left(V1′-V3′\right) ∗ Gisop + \left(V2′-V3′\right) ∗ Gison = - V 2 ′ ∗ G 2$ *at* $CHASSIS - GND : \left(V1"-V3"\right) ∗ Gisop + \left(V2"-V3"\right) ∗ Gison = - V 1 " ∗ G 1 - V 2 " ∗ G 2$

A first set of solutions can then be derived as follows: ${Gisop}_{1} = {Risop}_{1}^{- 1} = \frac{- V 1 ∗ V 2 ′ ∗ G 1 + V 1 ∗ V 3 ′ ∗ G 1 - V 2 ′ ∗ V 3 ∗ G 2 + V 2 ∗ V 2 ′ ∗ G 2}{V 1 ∗ V 2 ′ - V 1 ∗ V 3 ′ - V 2 ′ ∗ V 3 - V 1 ′ ∗ V 2 + V 2 ∗ V 3 ′ + V 1 ′ ∗ V 3}$ ${Gison}_{1} = {Rison}_{1}^{- 1} = \frac{- V 1 ∗ V 3 ′ ∗ G 1 + V 1 ∗ V 1 ′ ∗ G 1 - V 1 ∗ V 2 ′ ∗ G 2 + V 2 ′ ∗ V 3 ∗ G 2}{V 1 ∗ V 2 ′ - V 1 ∗ V 3 ′ - V 2 ′ ∗ V 3 - V 1 ′ ∗ V 2 + V 2 ∗ V 3 ′ + V 1 ′ ∗ V 3}$

A second set of solutions can then be derived as follows: $\begin{matrix}{Gisop}_{2} = {Risop}_{2}^{- 1} \\ = \frac{- V 1 ∗ V 2 " ∗ G 1 + V 1 ∗ V 3 " ∗ G 1 - V 1 " ∗ V 3 ∗ G 1 - V 2 " ∗ V 3 ∗ G 2 + V 1 " ∗ V 2 ∗ G 1 + V 2 ∗ V 2 " ∗ G 2}{V 1 ∗ V 2 " - V 1 ∗ V 3 " - V 2 " ∗ V 3 - V 1 " ∗ V 2 + V 2 ∗ V 3 " + V 1 " ∗ V 3}\end{matrix}$ $\begin{matrix}{Gison}_{2} = {Rison}_{2}^{- 1} \\ = \frac{- V 1 ∗ V 3 " ∗ G 1 + V 1 ∗ V 1 " ∗ G 1 - V 1 ∗ V 1 " ∗ G 1 - V 1 ∗ V 2 " ∗ G 2 + V 1 " ∗ V 3 ∗ G 1 + V 2 " ∗ V 3 ∗ G 2}{V 1 ∗ V 2 " - V 1 ∗ V 3 " - V 2 " ∗ V 3 - V 1 " ∗ V 2 + V 2 ∗ V 3 " + V 1 " ∗ V 3}\end{matrix}$

A third set of solutions can then be derived as follows: $\begin{matrix}{Gisop}_{3} = {Risop}_{3}^{- 1} \\ = \frac{- V 2 ′ ∗ V 2 " ∗ G 2 + V 2 ′ ∗ V 3 " ∗ G 2 - V 1 " ∗ V 3 ′ ∗ G 1 - V 2 " ∗ V 3 ′ ∗ G 2 + V 1 " ∗ V 2 ′ ∗ G 1 + V 2 ′ ∗ V 2 " ∗ G 2}{V 1 ′ ∗ V 2 " - V 1 ′ ∗ V 3 " - V 2 " ∗ V 3 ′ - V 1 " ∗ V 2 ′ + V 2 ′ ∗ V 3 " + V 1 " ∗ V 3 ′}\end{matrix}$ $\begin{matrix}{Gison}_{3} = {Rison}_{3}^{- 1} \\ = \frac{- V 2 ′ ∗ V 3 " ∗ G 2 + V 2 ′ ∗ V 1 " ∗ G 2 - V 1 ′ ∗ V 1 " ∗ G 1 - V 1 ′ ∗ V 2 " ∗ G 2 + V 1 " ∗ V 3 ′ ∗ G 1 + V 2 " ∗ V 3 ′ ∗ G 2}{V 1 ′ ∗ V 2 " - V 1 ′ ∗ V 3 " - V 2 " ∗ V 3 ′ - V 1 " ∗ V 2 ′ + V 2 ′ ∗ V 3 " + V 1 " ∗ V 3 ′}\end{matrix}$

An average over the derived positive isolation resistance Risop and the negative isolation resistance Rison can thus be calculated as: ${Risop}_{1} = \frac{1}{{Gisop}_{1}} , {Risop}_{2} = \frac{1}{{Gisop}_{2}} , {Risop}_{3} = \frac{1}{{Gisop}_{3}}$ ${Rison}_{1} = \frac{1}{{Gison}_{1}} , {Rison}_{2} = \frac{1}{{Gison}_{2}} , {Rison}_{3} = \frac{1}{{Gison}_{3}}$ $Risop = \frac{{Risop}_{1} + {Risop}_{2} + {Risop}_{3}}{3}$ $Rison = \frac{{Rison}_{1} + {Rison}_{2} + {Rison}_{3}}{3}$

### Reference signs

- 10: Battery pack
- BATP: Positive (plus) battery pole
- BATM: Negative (minus) battery pole
- Vbat: Voltage source
- CHASSIS-GND: Chassis ground
- LV-GND: Low-voltage (LV) ground
- N: Node
- Sw1, Sw2, Sw3: First to third switch
- R1, R2, R3: First to third resistor
- I1, I2, I3: First to third resistor current
- Risop, Rison: Positive and negative isolation resistance
- lisop, lison: Positive and negative isolation resistance current
- V1, V2, V3: First to third voltmeter

## Claims

1. A measurement circuit for measuring an isolation resistance of a battery pack (10), comprising:
a first electric connection comprising a first resistor (R1) and a controllable first switch (Sw1) in series connection, and connecting a positive pole (BATP) of the battery pack (10) to a chassis ground (CHASSIS-GND); and
a second electric connection comprising a second resistor (R2) and a controllable second switch (Sw2) in series connection, and connecting a negative pole (BATM) of the battery pack (10) to the chassis ground (CHASSIS-GND),
wherein a common connection from the first resistor (R1) and the second resistor (R2) to the chassis ground (CHASSIS-GND) comprises a third resistor (R3) in series connection, and
wherein, when the first switch (Sw1) is closed and the second switch (Sw2) is open, a first voltage drop over the first resistor (R1) and the first switch (Sw1) is measurable by a first voltmeter (V1), and, when the first switch (Sw1) is open and the second switch (Sw2) is closed, a second voltage drop over the second resistor (R2) and the second switch (Sw2) is measurable by a second voltmeter (V2).

2. The measurement circuit of claim 1, wherein the common connection is further connected to a low-voltage ground (LV-GND).

3. The measurement circuit of claim 1 or 2, wherein the resistance of the third resistor (R3) is equal to or less than 5 % of the resistance of the first resistor (R1) or the second resistor (R2).

4. The measurement circuit of any one of the preceding claims, wherein the common connection further includes a controllable third switch (Sw3).

5. The measurement circuit of claim 4, wherein, when the third switch (Sw3) and at least one of the first switch (Sw1) and the second switch (Sw2) are closed, a third voltage drop over the third resistor (R3) and the third switch (Sw3) is measurable by a third voltmeter (V3).

6. An electrical system of a vehicle, comprising a battery pack (10) and the measurement circuit according to any one of the preceding claims.

7. An electric vehicle, comprising the electrical system according to claim 6.

8. A method for measuring an isolation resistance of a battery pack (10) with a measurement circuit according to claim 5, comprising:
controlling the measurement circuit to a first state in which the first switch (Sw1) and the third switch (Sw3) are closed and the second switch (Sw2) is open, and measuring the voltages on the first to third voltmeter (V1, V2, V3) in the first state;
controlling the measurement circuit to a second state in which the second switch (Sw2) and the third switch are closed and the first switch (Sw1) is open, and measuring the voltages on the first to third voltmeter (V1', V2', V3') in the second state;
controlling the measurement circuit to a third state in which the first to third switch (Sw1, Sw2, Sw3) are closed and measuring the voltages on the first to third voltmeter (V1", V2", V3") in the third state.

9. The method according to claim 8, further comprising:
calculating and averaging the resistance value of the third resistor (R3) individually from the measured voltages (V1, V2, V3; V1', V2', V3'; V1", V2", V3") in the three states.

10. The method according to claim 9, further comprising:
calculating a pair of a positive isolation resistance (Risop) related to the first electric connection and a negative isolation resistance (Rison) related to the second electric connection for each of the three states;
averaging the resulting resistances of the positive isolation resistance (Risop);
averaging the resulting resistances of the negative isolation resistance (Rison).

## Amended claims

### Amended claims in accordance with Rule 137(2) EPC.

1. A measurement circuit for measuring an isolation resistance of a battery pack (10), comprising:
a first electric connection comprising a first resistor (R1) and a controllable first switch (Sw1) in series connection, and connecting a positive pole (BATP) of the battery pack (10) to a chassis ground (CHASSIS-GND);
a second electric connection comprising a second resistor (R2) and a controllable second switch (Sw2) in series connection, and connecting a negative pole (BATM) of the battery pack (10) to the chassis ground (CHASSIS-GND),
wherein a common connection from the first resistor (R1) and the second resistor (R2) to the chassis ground (CHASSIS-GND) comprises a third resistor (R3) in series connection; and
a first voltmeter (V1) and a second voltmeter (V2),
wherein, when the first switch (Sw1) is closed and the second switch (Sw2) is open, a first voltage drop over the first resistor (R1) and the first switch (Sw1) is measured by the first voltmeter (V1), and, when the first switch (Sw1) is open and the second switch (Sw2) is closed, a second voltage drop over the second resistor (R2) and the second switch (Sw2) is measured by the second voltmeter (V2).

2. The measurement circuit of claim 1, wherein the common connection is further connected to a low-voltage ground (LV-GND).

3. The measurement circuit of claim 1 or 2, wherein the resistance of the third resistor (R3) is equal to or less than 5 % of the resistance of the first resistor (R1) or the second resistor (R2).

4. The measurement circuit of any one of the preceding claims, wherein the common connection further includes a controllable third switch (Sw3).

5. The measurement circuit of claim 4, wherein, when the third switch (Sw3) and at least one of the first switch (Sw1) and the second switch (Sw2) are closed, a third voltage drop over the third resistor (R3) and the third switch (Sw3) is measurable by a third voltmeter (V3).

6. An electrical system of a vehicle, comprising a battery pack (10) and the measurement circuit according to any one of the preceding claims.

7. An electric vehicle, comprising the electrical system according to claim 6.

8. A method for measuring an isolation resistance of a battery pack (10) with a measurement circuit,
the measurement circuit comprising:
a first electric connection comprising a first resistor (R1) and a controllable first switch (Sw1) in series connection, and connecting a positive pole (BATP) of the battery pack (10) to a chassis ground (CHASSIS-GND); and
a second electric connection comprising a second resistor (R2) and a controllable second switch (Sw2) in series connection, and connecting a negative pole (BATM) of the battery pack (10) to the chassis ground (CHASSIS-GND),
wherein a common connection from the first resistor (R1) and the second resistor (R2) to the chassis ground (CHASSIS-GND) comprises a third resistor (R3) and a controllable third switch (Sw3) in series connection,
wherein, when the first switch (Sw1) is closed and the second switch (Sw2) is open, a first voltage drop over the first resistor (R1) and the first switch (Sw1) is measurable by a first voltmeter (V1), when the first switch (Sw1) is open and the second switch (Sw2) is closed, a second voltage drop over the second resistor (R2) and the second switch (Sw2) is measurable by a second voltmeter (V2), and when the third switch (Sw3) and at least one of the first switch (Sw1) and the second switch (Sw2) are closed, a third voltage drop over the third resistor (R3) and the third switch (Sw3) is measurable by a third voltmeter (V3);
the method comprising:
controlling the measurement circuit to a first state in which the first switch (Sw1) and the third switch (Sw3) are closed and the second switch (Sw2) is open, and measuring the voltages on the first to third voltmeter (V1, V2, V3) in the first state;
controlling the measurement circuit to a second state in which the second switch (Sw2) and the third switch are closed and the first switch (Sw1) is open, and measuring the voltages on the first to third voltmeter (V1', V2', V3') in the second state;
controlling the measurement circuit to a third state in which the first to third switch (Sw1, Sw2, Sw3) are closed and measuring the voltages on the first to third voltmeter (V1", V2", V3") in the third state.

9. The method according to claim 8, further comprising:
calculating and averaging the resistance value of the third resistor (R3) individually from the measured voltages (V1, V2, V3; V1', V2', V3'; V1", V2", V3") in the three states.

10. The method according to claim 9, further comprising:
calculating a pair of a positive isolation resistance (Risop) related to the first electric connection and a negative isolation resistance (Rison) related to the second electric connection for each of the three states;
averaging the resulting resistances of the positive isolation resistance (Risop);
averaging the resulting resistances of the negative isolation resistance (Rison).
